# EUROPEAN PATENT SPECIFICATION

(11) **EP 4 357 480 B1**
(45) Date of publication and mention of the grant of the patent: **10.12.2025**
(21) Application number: 23836704.9
(22) Date of filing: 13.02.2023
(51) Int. Cl.: C23C 14/24, C23C 14/54

(54) **DISTRIBUTOR FOR MATERIALS TO BE DEPOSITED AND VACUUM DEPOSITION DEVICE**
VERDAMPFUNGSMATERIALVERTEILER UND VAKUUMVERDAMPFUNGSVORRICHTUNG
DISTRIBUTEUR DE MATÉRIAUX À DÉPOSER ET DISPOSITIF DE DÉPÔT SOUS VIDE

(30) Priority: 08.09.2022 CN 202211093350
(43) Date of publication of application: 24.04.2024
(73) Proprietor: Chongqing Jimat New Material Technology Co., Ltd., Qijiang District, Chongqing 401421 (CN)
(72) Inventor: ZANG, Shiwei, Qijiang District, Chongqing 401421 (CN)
(74) Representative: Novagraaf Group
(86) International application number: PCT/CN2023/075621
(87) International publication number: WO 2024/051083

(56) References cited:
- CN-A- 113 981 378
- CN-A- 113 981 378
- CN-A- 115 449 755
- CN-U- 202 369 108
- CN-U- 214 002 230
- JP-A- S6 066 120
- US-A1- 2004 245 283

## Description

### TECHNICAL FIELD

The present disclosure relates to the technical field of vacuum evaporation, and in particular to an evaporation material distributor and a vacuum evaporation device.

### BACKGROUND

Vacuum evaporation involves placing a to-be-evaporated material into a crucible under vacuum conditions and then heating the crucible. The existing vacuum evaporation applications concern a plurality of crucibles that are subjected to evaporation together. The to-be-evaporated material is placed into the crucibles one by one, resulting in low efficiency. Moreover, it is difficult to place an equal amount of the to-be-evaporated material into each crucible, causing nonuniformity of the material evaporated to a thin film, thereby affecting product quality. CN113981378A discloses a vacuum material uniformizing and filling evaporation equipment which comprises a filling bin, a deposition bin and a material metering mechanism. The filling bin is provided with an evacuation valve, and a storage box is arranged in the filling bin; the deposition bin is arranged below the filling bin and is communicated with the filling bin; the material metering mechanism is located in a material mixing bin and movably arranged in the material filling bin or the deposition bin; and a first valve is arranged between the material metering mechanism and the material storage box. US2004/245283A1 discloses a volumetric feeder for powder or granular material. The volumetric feeder is made of a plurality of independent feeder elements. Each of the feeder elements is provided with a stationary portion and a movable volumetric measure that can move back and forth in the stationary portion. Each movable volumetric measure is provided with a measure portion for accommodating a predetermined volume of powdery or granular material. The movable volumetric measures in the feeder elements are capable of moving, independently of one another, between a powdery- or granular-material-charging position at which the measure portions coincide with charging apertures of the stationary portion, and a powdery- or granular-material-discharging position at which the measure portions coincide with discharging apertures of the stationary portion.

### SUMMARY

### (I) Technical problem to be solved

In view of defects and shortages of the prior art, the present disclosure provides an evaporation material distributor, to solve the technical problem that when a to-be-evaporated material is placed into crucibles, it is hard to place an equal to-be-evaporated material into each crucible to cause nonuniformity of the material evaporated to a thin film.

### (II) Technical solutions

To achieve the above objective, the present disclosure adopts the following main technical solutions:

According to an aspect, the present disclosure provides an evaporation material distributor. The evaporation material distributor includes a material distribution mechanism and a housing, where the material distribution mechanism is provided at a bottom of the housing, and the material distribution mechanism includes a plurality of through holes formed inside the material distribution mechanism at intervals along a length direction of the material distribution mechanism; and a plurality of feeding channels respectively provided at two sides of the material distribution mechanism, and corresponding to the holes, wherein each of the feeding channels communicates with a corresponding one of the holes. The material distribution mechanism further includes a plurality of guide tubes respectively provided at bottoms of the holes. The material distribution mechanism further includes a plurality of locating tubes; the locating tubes are respectively sleeved on inner sidewalls of the guide tubes; the locating tube is longer than the guide tube; and the locating tube includes one end connected to the hole, and the other end communicating with a crucible. Gaps are respectively provided at tangents between the plurality of through holes and the plurality of feeding channels; the material distributor further includes a barrier, the barrier includes a top plate and barrier plates, the barrier plates are vertically connected to the top plate, and the barrier plates are respectively inserted into the gaps; and a width of the barrier plate is the same as a depth of the feeding channel. The material distribution mechanism further includes a slider provided in the feeding channel; a hollow locating rod threadedly connected to a sidewall of the material distribution mechanism through a bolt, and corresponding to the feeding channel; and an adjusting threaded rod fixedly connected to the slider through the hollow locating rod. The material distribution mechanism further includes a baffle plate provided on the feeding channel; and an edge of a side of the baffle plate close to the hole is fixedly connected to the slider.

Optionally, the plurality of through holes are formed in a middle of the material distribution mechanism in two rows.

Optionally, a handle is provided on the top plate.

Optionally, the housing is trumpet-shaped.

According to another aspect, the present disclosure further provides a vacuum evaporation device, including the above-mentioned evaporation material distributor.

### (III) Beneficial effects

The present disclosure has following beneficial effects:

The evaporation material distributor provided by the present disclosure includes a material distribution mechanism and a housing. The material distribution mechanism is provided at a bottom of the housing. The material distribution mechanism includes a plurality of through holes formed in a middle of a bottom of the material distribution mechanism along a length direction of the material distribution mechanism, and a plurality of feeding channels respectively provided between the holes and corresponding edges of the material distribution mechanism. Compared with the prior art, the evaporation material distributor can uniformly place a to-be-evaporated material into each crucible through the plurality of channel and the plurality of through holes.

### BRIEF DESCRIPTION OF THE DRAWINGS

FIG. 1 is an overall schematic structural view of an evaporation material distributor according to a specific implementation of the present disclosure;
FIG. 2 is an overall schematic structural view of another evaporation material distributor according to a specific implementation of the present disclosure;
FIG. 3 is a right view of an evaporation material distributor according to a specific implementation of the present disclosure;
FIG. 4 is a bottom view of an evaporation material distributor according to a specific implementation of the present disclosure;
FIG. 5 is a schematic structural view of a guide tube and a locating tube according to a specific implementation of the present disclosure;
FIG. 6 is an overall schematic structural view of a barrier according to a specific implementation of the present disclosure;
FIG. 7 is a top view of an evaporation material distributor according to a specific implementation of the present disclosure;
FIG. 8 is a perspective view of an evaporation material distributor according to a specific implementation of the present disclosure;
FIG. 9 is a front view of an evaporation material distributor according to a specific implementation of the present disclosure;
FIG. 10 is a partially enlarged view of an evaporation material distributor according to a specific implementation of the present disclosure; and
FIG. 11 is a schematic structural view of a connection between a baffle plate and a slider according to a specific implementation of the present disclosure.

### [Reference numerals]

1: material distribution mechanism, 10: hole, 11: feeding channel, 12: guide tube, 13: locating tube, 14: gap, 15: slider, 16: hollow locating rod, 17: bolt, 18: adjusting threaded rod, and 19: baffle plate;
2: housing; and
3: barrier, 31: top plate, 32: barrier plate, and 33: handle.

### DETAILED DESCRIPTION OF THE EMBODIMENTS

In order to facilitate a better understanding of the above technical solutions, the exemplary embodiments of the present disclosure are described in more detail below with reference to the accompanying drawings. Although the accompanying drawings show exemplary embodiments of the present disclosure, it should be understood that the present disclosure may be implemented in various forms and should not be limited to the embodiments set forth herein. The embodiments are provided for a more thorough understanding of the present disclosure, so as to make the scope of the present disclosure be fully conveyed to those skilled in the art.

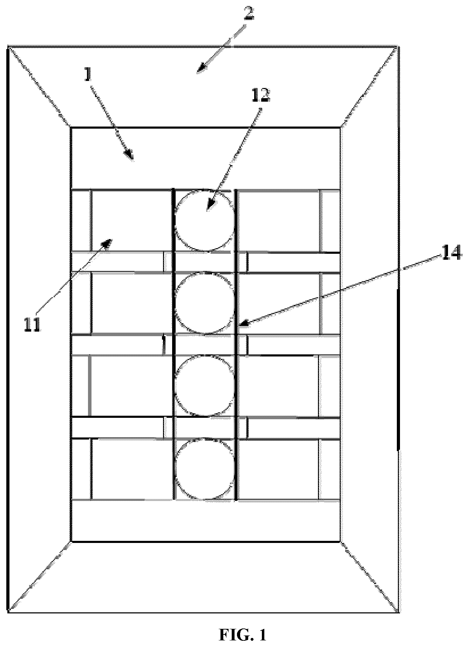

As shown in FIG. 1, a specific implementation of the present disclosure provides an evaporation material distributor, including material distribution mechanism 1 and housing 2. The material distribution mechanism 1 is provided at a bottom of the housing 2. The material distribution mechanism 1 includes a plurality of through holes 10 and a plurality of feeding channels 11. The plurality of through holes 10 are formed in a middle of the material distribution mechanism 1 at intervals along a length direction of the material distribution mechanism 1. The plurality of feeding channels 11 are respectively located at two sides of the material distribution mechanism 1, and corresponding to the through holes 10. Each of the feeding channels 11 communicates with a corresponding one of the holes 10. In the embodiment, one row of the holes 10 are formed in the middle of the material distribution mechanism 1, and the feeding channels 11 are respectively located at two sides of the row of the holes 10. Each hole 10 corresponds to two feeding channels 11. A to-be-evaporated material is placed into the feeding channels 11 first, and then enters the plurality of holes 10 through the feeding channels 11. Through the plurality of through holes 10, the to-be-evaporated material is placed into crucibles. In the embodiment, each hole 10 corresponds to two feeding channels 11, such that the to-be-evaporated material can be distributed quickly and uniformly. It is to be noted that a number of the holes 10 can be set according to a number of the crucibles.

The evaporation material distributor provided by the present disclosure can place the to-be-evaporated material into the crucibles uniformly at the same time, such that the material evaporated to a thin film is uniform. This can improve a production efficiency and a product quality.

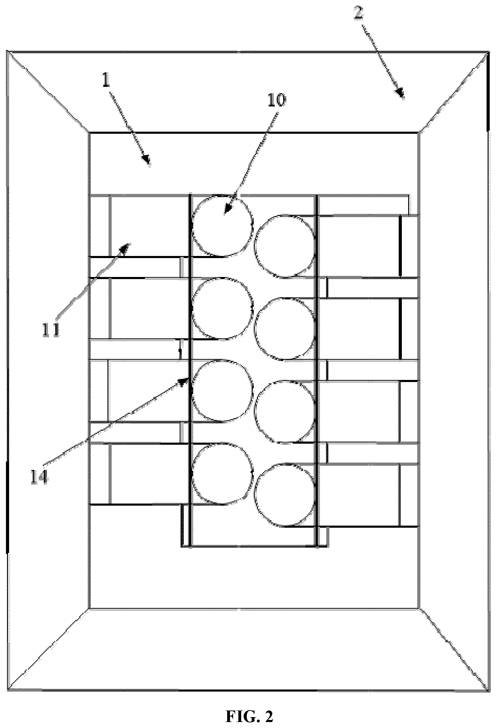

As shown in FIG. 2, in some embodiments, the plurality of through holes 10 may be formed in the middle of the material distribution mechanism 1 in two rows. Between each row of the holes 10 and a corresponding edge of the material distribution mechanism 1, the feeding channels 11 are provided correspondingly. In addition, the plurality of through holes 10 can be provided in one row or two rows according to a number of the crucibles and a size of the material distribution mechanism 1, such as a length and a width of the material distribution mechanism 1. For example, in response to a greater length and a smaller width of the material distribution mechanism 1, the plurality of through holes 10 can be provided in one row. In this case, the feeding channels 11 are respectively provided between the one row of the holes 10 and edges at two sides of the material distribution mechanism 1, namely each hole 10 corresponds to two feeding channels 11. In response to a smaller length and a greater width of the material distribution mechanism 1, the plurality of through holes 10 can be provided in two rows. In this case, the feeding channels 11 are respectively provided between each row of the holes 10 and a corresponding edge at one side of the material distribution mechanism 1, namely each hole 10 corresponds to one feeding channel 11. In the embodiment of the present disclosure, positions of the holes 10 can be provided flexibly according to the size of the material distribution mechanism 1.

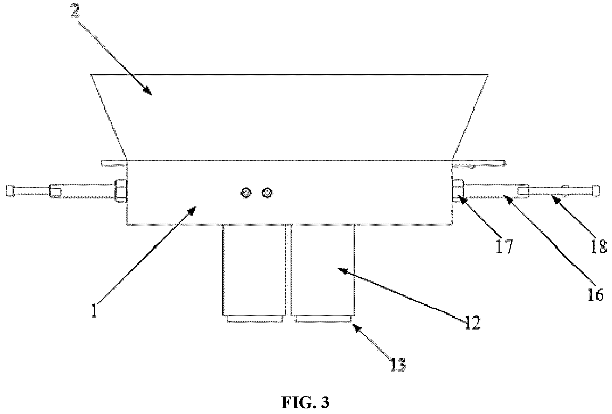

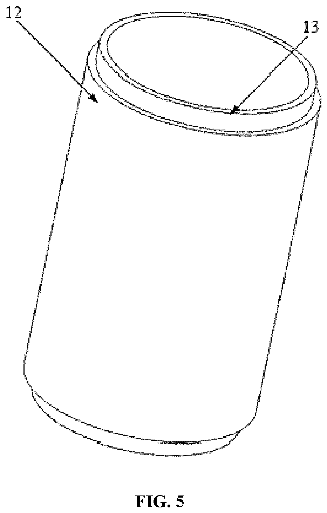

As shown in FIG. 3 to FIG. 5, in some embodiments, the material distribution mechanism 1 further includes a plurality of guide tubes 12 respectively provided at bottoms of the holes 10. In the embodiment, the to-be-evaporated material is guided to the crucible through the guide tube 12. Usually, the crucible is circular. Through the circular guide tube 12, the to-be-evaporated material is completely guided to each crucible. This prevents the to-be-evaporated material from splashing to the outside to cause nonuniformity of the to-be-evaporated material in each crucible.

As shown in FIG. 3 to FIG. 5, in some embodiments, the material distribution mechanism 1 further includes a plurality of locating tubes 13. The locating tubes 13 are respectively sleeved on inner sidewalls of the guide tubes 12. The locating tube 13 is longer than the guide tube 12. The locating tube 13 includes one end connected to the hole 10, and the other end connected to a crucible. That is, the guide tube 12 is fixed under the hole 10 through the locating tube 13. With the locating tube 13, the guide tube 12 can be in one-to-one correspondence with the crucible. The locating tube 13 is sleeved on the inner sidewall of the guide tube 12, and the locating tube 13 is longer than the guide tube 12, such that protrusive steps are provided at two ends of a whole portion formed by the guide tube 12 and the locating tube 13. The extended step portion includes one end connected to the crucible, and the other end connected to the hole 10 of the material distribution mechanism 1. In the embodiment of the present disclosure, the guide tube 12 is located through the locating tube 13. The guide tube can be directly located to the crucible. This can guide the to-be-evaporated material to the crucible more conveniently.

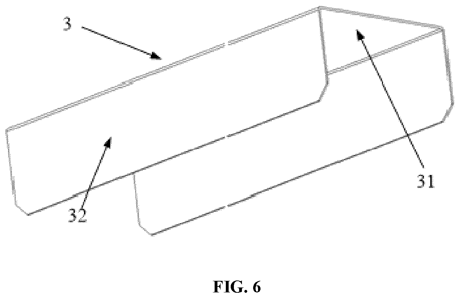

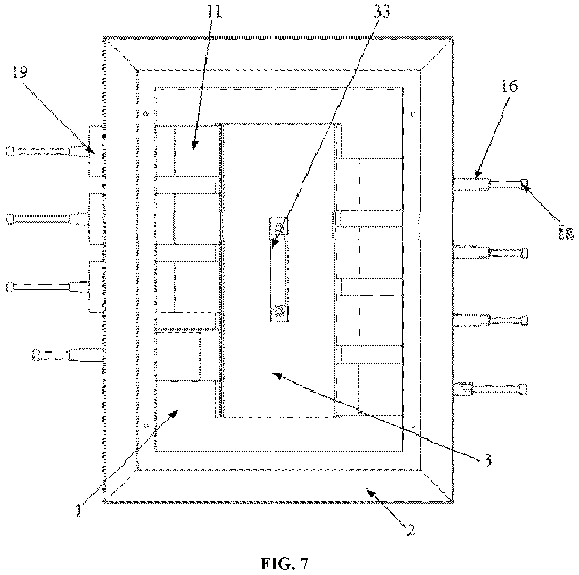

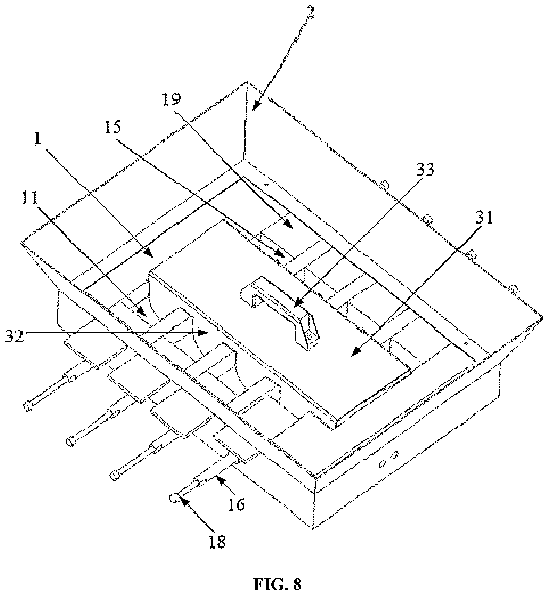

As shown in FIG. 1, FIG. 2, FIG. 6, FIG. 7 and FIG. 8, in some embodiments, gaps 14 are provided at tangents between the plurality of through holes 10 and the plurality of feeding channels 11. That is, the gaps 14 are provided at junctions between the plurality of through holes 10 and the plurality of feeding channels 11 and at tangents of the plurality of through holes 10. The material distributor further includes barrier 3. The barrier 3 includes top plate 31 and barrier plates 32. The barrier plates 32 are vertically connected to the top plate 31. The barrier plates 32 are respectively inserted into the gaps 14. A width of the barrier plate 32 is the same as a depth of the feeding channel 11 to fittingly separate the feeding channel 11 and the hole 10. In the embodiment of the present disclosure, with the barrier 3 for separating the hole 10 and the feeding channel 11, the to-be-evaporated material does not fall into the crucible through the hole 10 in advance in material distribution to cause non-uniform material distribution. Optionally, handle 33 may further be provided on the top plate 31, so as to place and take out the barrier 3 conveniently. Optionally, a chamfer may be provided at a bottom of each of left and right sides of the barrier plate 32. A chamfer may also be provided at an edge of the corresponding gap 14. The chamfer ranges from 30° to 60°. In this way, the barrier plate 32 can be inserted into the gap 14 more conveniently.

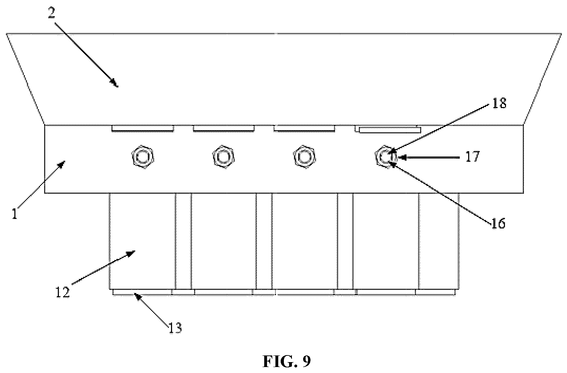

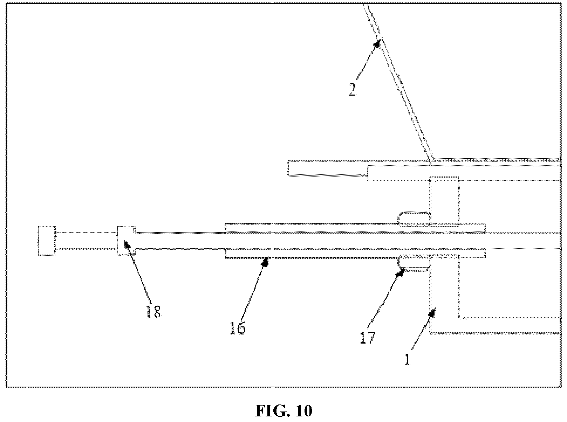

As shown in FIG. 3, FIG. 4, FIG. 7, FIG. 8, FIG. 9 and FIG. 10, in some embodiments, the material distribution mechanism 1 further includes slider 15, hollow locating rod 16, bolt 17, and adjusting threaded rod 18. The slider 15 is provided in the feeding channel 11. The hollow locating rod 16 is threadedly connected to a sidewall of the material distribution mechanism 1 through the bolt 17, and corresponds to the feeding channel 11. The adjusting threaded rod 18 is fixedly connected to the slider 15 through the hollow locating rod 16. In the embodiment of the present disclosure, the slider 15 is pulled and pushed through the adjusting threaded rod 18. When the slider is pulled, the to-be-evaporated material is placed into the feeding channel 11. The to-be-evaporated material is pushed into the hole 10 by pushing the slider 15 and then guided to the crucible through the guide tube 12. In addition, by rotating the hollow locating rod 16, a length of the hollow locating rod 16 penetrated into the feeding channel 11 can be adjusted. The slider 15 is located through the hollow locating rod 16, such that the slider 15 in the feeding channel 11 is located at a same position to quantify the to-be-evaporated material.

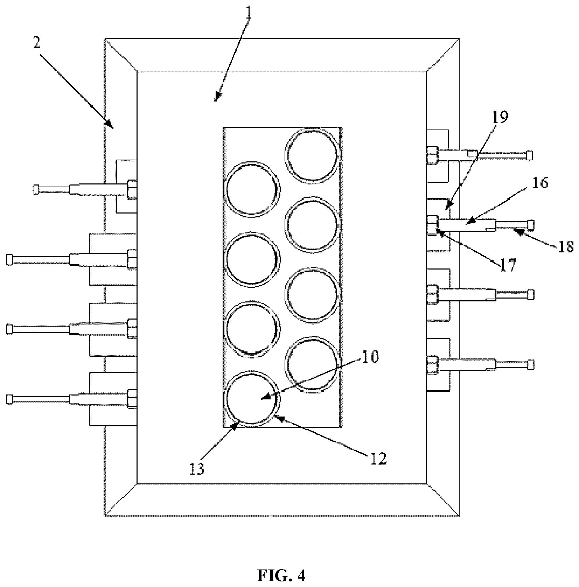

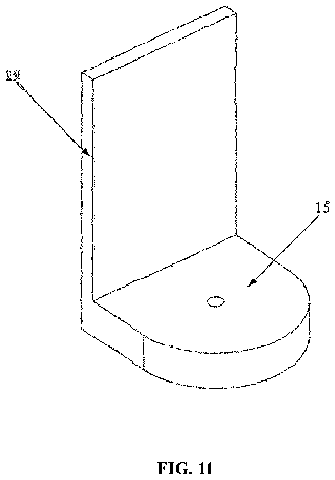

As shown in FIG. 4, FIG. 7, FIG. 8 and FIG. 11, in some embodiments, the material distribution mechanism 1 further includes baffle plate 19. The baffle plate 19 is provided on the feeding channel 11. An edge of a side of the baffle plate 19 close to the hole 10 is fixedly connected to the slider 15. Specifically, the slider 15 is shorter than the feeding channel 11. The slider 15 divides the feeding channel 11 into a side close to the hole 10 and a side away from the hole 10. The baffle plate 19 shields the feeding channel 11 at the side away from the hole 10. In this way, the to-be-evaporated material falls completely into the feeding channel 11 at the side close to the hole 10, thereby entering the crucible through the hole 10. In the embodiment of the present disclosure, the baffle plate 19 shields the feeding channel 11 between the slider 15 and the edge of the material distribution mechanism 1. In the material distribution, this prevents the to-be-evaporated material (copper particles or aluminum particles) from falling into the feeding channel 11 between the slider 15 and the edge of the material distribution mechanism 1.

In some embodiments, the housing 2 may be trumpet-shaped. This can prevent the to-be-evaporated material from scattering to the ground in the material distribution to waste the material and cause environmental pollution.

The present disclosure further provides a vacuum evaporation device. The vacuum evaporation device includes any evaporation material distributor described above. With the evaporation material distributor for material distribution, not only is a thin-film evaporation efficiency improved, but also the to-be-evaporated material can be uniformly placed into each crucible to improve a thin-film evaporation quality.

The evaporation material distributor provided by the present disclosure has a following working principle:
The barrier 3 covers the plurality of through holes 10 in the material distribution mechanism 1, and separates the holes 10 and the feeding channels 11. The slider 15 is pulled to the hollow locating rod 16 through the adjusting threaded rod 18, thereby locating the slider 15. The to-be-evaporated material (such as copper particles or aluminum particles) is placed into the feeding channel 11. The barrier 3 is lifted by the handle 33. The slider 15 is pushed through the adjusting threaded rod 18, thereby pushing the to-be-evaporated material in the feeding channel 11 into the hole 10. The to-be-evaporated material is guided to the crucible through the guide tube 12 and the locating tube 13, thereby realizing uniform distribution of the material.

The present disclosure has the following beneficial effects:
The evaporation material distributor provided by the present disclosure can place the to-be-evaporated material into the crucibles uniformly at the same time, such that the material evaporated to a thin film is uniform. This can improve a production efficiency and a product quality.

According to the evaporation material distributor provided by the present disclosure, positions of the holes 10 can be provided flexibly according to the size of the material distribution mechanism 1.

According to the evaporation material distributor provided by the present disclosure, the to-be-evaporated material is guided to the crucible through the guide tube 12. Usually, the crucible is circular. Through the circular guide tube 12, the to-be-evaporated material is completely guided to each crucible. This prevents the to-be-evaporated material from splashing to the outside to cause nonuniformity of the to-be-evaporated material in each crucible.

According to the evaporation material distributor provided by the present disclosure, the guide tube 12 is located through the locating tube 13. The guide tube can be directly located to the crucible. This can guide the to-be-evaporated material to the crucible more conveniently.

According to the specific implementation of the present disclosure, with the barrier 3 for separating the hole 10 and the feeding channel 11, the to-be-evaporated material does not fall into the crucible through the hole 10 in advance in material distribution to cause non-uniform material distribution. Optionally, handle 33 may further be provided on the top plate 31, so as to place and take out the barrier 3 conveniently.

According to the specific implementation of the present disclosure, the slider 15 is pulled and pushed through the adjusting threaded rod 18. When the slider is pulled, the to-be-evaporated material is placed into the feeding channel 11. The to-be-evaporated material is pushed into the hole 10 by pushing the slider 15 and then guided to the crucible through the guide tube 12. In addition, the slider 15 is located through the hollow locating rod 16, such that the slider 15 in the feeding channel 11 is located at a same position to quantify the to-be-evaporated material.

According to the specific implementation of the present disclosure, the baffle plate 19 shields the feeding channel 11 between the slider 15 and the edge of the material distribution mechanism 1. In the material distribution, this can prevent the to-be-evaporated material (copper particles or aluminum particles) from falling into the feeding channel 11 between the slider 15 and the edge of the material distribution mechanism 1.

According to the specific implementation of the present disclosure, the housing 2 may be trumpet-shaped. This can prevent the to-be-evaporated material from scattering to the ground in the material distribution to waste the material and cause environmental pollution.

## Claims

1. An evaporation material distributor, comprising:
a material distribution mechanism (1) and a housing (2), wherein the material distribution mechanism (1) is provided at a bottom of the housing (2); and
the material distribution mechanism (1) comprises a plurality of through holes (10) formed inside the material distribution mechanism (1) at intervals along a length direction of the material distribution mechanism (1), wherein the material distribution mechanism (1) further comprises a plurality of guide tubes (12) respectively provided at bottoms of the holes (10); and
**characterized in that**
a plurality of feeding channels (11) is respectively provided at two sides of the material distribution mechanism (1), and corresponding to the holes (10), wherein each of the feeding channels (11) communicates with a corresponding one of the holes (10);
the material distribution mechanism (1) further comprises a plurality of locating tubes (13); and the locating tubes (13) are respectively sleeved on inner sidewalls of the guide tubes (12); and the locating tube (13) is longer than the guide tube (12); and the locating tube (13) comprises one end connected to the hole (10), and the other end communicating with a crucible;
gaps (14) are respectively provided at tangents between the plurality of through holes (10) and the plurality of feeding channels (11); the material distributor further comprises a barrier (3), the barrier (3) comprises a top plate (31) and barrier plates (32), the barrier plates (32) are vertically connected to the top plate (31), and the barrier plates (32) are respectively inserted into the gaps (14); and a width of the barrier plate (32) is the same as a depth of the feeding channel (11);
the material distribution mechanism (1) further comprises a slider (15) provided in each of the feeding channels (11); a hollow locating rod (16) threadedly connected to a sidewall of the material distribution mechanism (1) through a bolt (17), and corresponding to each of the feeding channels (11); and an adjusting threaded rod (18) fixedly connected to the slider (15) through the hollow locating rod (16);
the material distribution mechanism (1) further comprises a baffle plate (19) provided on each of the feeding channels (11); and an edge of a side of the baffle plate (19) close to the hole (10) is fixedly connected to the slider (15).

2. The evaporation material distributor according to claim 1, wherein
the plurality of through holes (10) are formed in a middle of the material distribution mechanism (1) in two rows.

3. The evaporation material distributor according to claim 1, wherein
a handle (33) is provided on the top plate (31).

4. The evaporation material distributor according to claim 1, wherein
the housing (2) is trumpet-shaped.

5. A vacuum evaporation device, comprising the evaporation material distributor according to any one of claims 1 to 4.

## Patentansprüche

1. Verdampfungsmaterialverteiler, umfassend:
einen Materialverteilungsmechanismus (1) und ein Gehäuse (2), wobei der Materialverteilungsmechanismus (1) an einem Boden des Gehäuses (2) bereitgestellt ist; und
der Materialverteilungsmechanismus (1) eine Vielzahl von Durchgangslöchern (10) umfasst, die im Inneren des Materialverteilungsmechanismus (1) in Abständen entlang einer Längsrichtung des Materialverteilungsmechanismus (1) ausgebildet sind, wobei der Materialverteilungsmechanismus (1) ferner eine Vielzahl von Führungsrohren (12) umfasst, die jeweils am Boden der Löcher (10) bereitgestellt sind; und
**dadurch gekennzeichnet, dass**
eine Vielzahl von Zuführkanälen (11) jeweils an zwei Seiten des Materialverteilungsmechanismus (1) bereitgestellt ist und den Löchern (10) entspricht, wobei jeder der Zuführkanäle (11) mit einem entsprechenden einen der Löcher (10) in Verbindung steht;
der Materialverteilungsmechanismus (1) ferner eine Vielzahl von Positionierungsrohren (13) umfasst; und die Positionierungsrohre (13) jeweils auf Innenseitenwände der Führungsrohre (12) gestülpt sind; und das Positionierungsrohr (13) länger ist als das Führungsrohr (12); und das Positionierungsrohr (13) ein Ende umfasst, das mit dem Loch (10) verbunden ist, und das andere Ende mit einem Tiegel in Verbindung steht;
jeweils Lücken (14) an den Tangenten zwischen der Vielzahl von Durchgangslöchern (10) und der Vielzahl von Zuführkanälen (11) bereitgestellt sind; der Materialverteiler ferner eine Barriere (3) umfasst, die Barriere (3) eine obere Platte (31) und Barriereplatten (32) umfasst, die Barriereplatten (32) vertikal mit der oberen Platte (31) verbunden sind und die Barriereplatten (32) jeweils in die Lücken (14) eingesetzt sind; und eine Breite der Barriereplatte (32) gleich einer Tiefe des Zuführkanals (11) ist;
der Materialverteilungsmechanismus (1) ferner einen Schieber (15) umfasst, der in jedem der Zuführkanäle (11) bereitgestellt ist; eine hohle Positionierungsstange (16), die über eine Schraube (17) mit einer Seitenwand des Materialverteilungsmechanismus (1) mittels Gewinde verbunden ist und jedem der Zuführkanäle (11) entspricht; und eine Einstellgewindestange (18), die durch die hohle Positionierungsstange (16) fest mit dem Schieber (15) verbunden ist;
der Materialverteilungsmechanismus (1) ferner eine Prallplatte (19) umfasst, die an jedem der Zuführkanäle (11) bereitgestellt ist; und eine Kante einer Seite der Prallplatte (19) nahe dem Loch (10) fest mit dem Schieber (15) verbunden ist.

2. Verdampfungsmaterialverteiler nach Anspruch 1, wobei die Vielzahl von Durchgangslöchern (10) in einer Mitte des Materialverteilungsmechanismus (1) in zwei Reihen ausgebildet ist.

3. Verdampfungsmaterialverteiler nach Anspruch 1, wobei an der oberen Platte (31) ein Griff (33) bereitgestellt ist.

4. Verdampfungsmaterialverteiler nach Anspruch 1, wobei das Gehäuse (2) trompetenförmig ist.

5. Vakuumverdampfungsvorrichtung, umfassend den Verdampfungsmaterialverteiler nach einem der Ansprüche 1 bis 4.

## Revendications

1. Distributeur de matériaux d'évaporation comprenant :
un mécanisme de distribution de matériaux (1) et un boîtier (2), dans lequel le mécanisme de distribution de matériaux (1) est prévu au fond du boîtier (2) ; et
le mécanisme de distribution de matériaux (1) comprend une pluralité d'orifices de passage (10) formés à l'intérieur du mécanisme de distribution de matériaux (1) à intervalles le long de la direction longitudinale du mécanisme de distribution de matériaux (1), dans lequel le mécanisme de distribution de matériaux (1) comprend en outre une pluralité de tubes de guidage (12) respectivement prévus au fond des orifices (10) ; et
**caractérisé en ce que**
une pluralité de canaux d'alimentation (11) est respectivement prévue sur les deux côtés du mécanisme de distribution de matériaux (1), et correspondant aux orifices (10), dans lequel chacun des canaux d'alimentation (11) communique avec un orifice correspondant (10) ;
le mécanisme de distribution de matériaux (1) comprend en outre plusieurs tubes de positionnement (13) ; et les tubes de positionnement (13) sont respectivement manchonnés sur les parois latérales intérieures des tubes de guidage (12) ; et le tube de positionnement (13) est plus long que le tube de guidage (12) ; et le tube de positionnement (13) comprend une extrémité reliée à l'orifice (10) et l'autre extrémité communiquant avec un creuset ;
des interstices (14) sont respectivement prévus aux tangentes entre la pluralité d'orifices de passage (10) et la pluralité de canaux d'alimentation (11) ; le distributeur de matériaux comprend en outre une barrière (3), la barrière (3) comprend une plaque supérieure (31) et des plaques de barrière (32), les plaques de barrière (32) sont reliées verticalement à la plaque supérieure (31), et les plaques de barrière (32) sont respectivement insérées dans les interstices (14) ; et la largeur de la plaque de barrière (32) est identique à la profondeur du canal d'alimentation (11) ;
le mécanisme de distribution de matériaux (1) comprend en outre un curseur (15) placé dans chacun des canaux d'alimentation (11) ; une tige de positionnement creuse (16) reliée par filetage par un boulon (17) à une paroi latérale du mécanisme de distribution de matériaux (1) et correspondant à chacun des canaux d'alimentation (11) ; et une tige filetée de réglage (18) reliée de manière fixe au glisseur (15) par l'intermédiaire de la tige creuse de positionnement (16) ;
le mécanisme de distribution de matériaux (1) comprend en outre un déflecteur (19) placé sur chacun des canaux d'alimentation (11) ; et un bord d'un côté du déflecteur (19) proche de l'orifice (10) est relié de manière fixe au glisseur (15).

2. Distributeur de matériaux d'évaporation selon la revendication 1, dans lequel
la pluralité d'orifices de passage (10) sont formés au milieu du mécanisme de distribution de matériaux (1) en deux rangées.

3. Distributeur de matériaux d'évaporation selon la revendication 1, dans lequel
une poignée (33) est prévue sur la plaque supérieure (31).

4. Distributeur de matériaux d'évaporation selon la revendication 1, dans lequel
le boîtier (2) est en forme de trompette.

5. Dispositif d'évaporation sous vide, comprenant le distributeur de matériau d'évaporation selon l'une quelconque des revendications 1 à 4.
